(19) Europäisches Patentamt
European Patent Office
Office européen des brevets

(11) **EP 3 208 623 B1**

(12) **EUROPEAN PATENT SPECIFICATION**

(45) Date of publication and mention
of the grant of the patent:
**25.08.2021 Bulletin 2021/34**

(21) Application number: **17154870.4**

(22) Date of filing: **06.02.2017**

(51) Int Cl.:
*G01R 31/52* (2020.01)  *H02H 7/08* (2006.01)
*H02H 7/12* (2006.01)  *H02H 3/08* (2006.01)
*H02H 3/10* (2006.01)  *G01R 31/28* (2006.01)
*G05B 23/02* (2006.01)  *H02H 3/02* (2006.01)
*H02P 29/024* (2016.01)

(54) **HIGH IMPEDANCE ARC FAULT DETECTION**

DETEKTION VON LICHTBOGENFEHLERN MIT HOHER IMPEDANZ

DÉTECTION DE DÉFAILLANCE D'ARC ÉLECTRIQUE À HAUTE IMPÉDANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **05.02.2016 US 201615016338**

(43) Date of publication of application:
**23.08.2017 Bulletin 2017/34**

(73) Proprietor: **Hamilton Sundstrand Corporation
Charlotte, NC 28217 (US)**

(72) Inventors:
• **SAID, Waleed M.
Rockford, IL 61114 (US)**

• **BAX, Randall
Rockton, IL 61072 (US)**

(74) Representative: **Dehns
St. Bride's House
10 Salisbury Square
London EC4Y 8JD (GB)**

(56) References cited:
**EP-A1- 0 152 579    EP-A2- 2 677 618
GB-A- 2 512 632    US-A- 3 215 896
US-A- 5 537 327    US-A1- 2009 296 289**

## Description

## TECHNICAL FIELD

The present disclosure relates generally to arc fault detection, and more specifically to detection of a high impedance arc fault.

## BACKGROUND

Power conversion applications, such as those utilized in motor controllers, inherently include the possibility of arcing events where an electrically live component, such as a power terminal or a bus bar, arcs to another power terminal of different voltage or to a grounded housing or cold plate. Such arcing can occur for any number of reasons including, but not limited to, insufficient voltage withstand design margin, foreign objects component failure, manufacturing variability, manufacturing stresses, and contamination.

Typically, arc events are protected against via the inclusion of circuit breakers, fuses, or other similar fault protection devices. In operation, these types of fault protection devices trigger when a current through the fault protection device, or through a corresponding current sensor, exceeds a predetermined current threshold. When an arc event occurs and results in a circuit having a high impedance (high resistance to current flow), the current flow through the system can be lower than the trip threshold for the fault protection circuit. In such a case, the fault condition is not detected by the fault protection circuit, and damage resulting from the arc event can be compounded.

The following documents disclose methods and controllers for detecting a high impedance fault in an electrical circuit: US 2009/296289 and EP2677618.

## SUMMARY OF THE INVENTION

A method according to the invention for detecting a high impedance fault in an electrical circuit is provided as claimed in claim 1.

Another example of the above described exemplary method for detecting a high impedance fault in an electrical circuit further includes activating fault protection circuit in response to determining that a high impedance fault exists.

Another example of any of the above described exemplary methods for detecting a high impedance fault in an electrical circuit includes activating a fault protection device comprises simulating a low impedance fault, thereby tripping the fault protection device.

Another example of any of the above described exemplary methods for detecting a high impedance fault in an electrical circuit includes simulating a low impedance fault comprises placing a DC/AC converter within the electrical circuit in a crowbar mode.

Another example of any of the above described exemplary method for detecting a high impedance fault in an electrical circuit further includes calculating the common mode current of the three phase supply input of the operational model from the phases a, b and c at the three phase supply input, and calculating an input differential mode current, an output common mode current, an output differential mode current, the common mode current in the DC link, and a differential mode current in the DC link.

In another example of any of the above described exemplary methods for detecting a high impedance fault in an electrical circuit the expected operations model is a model of expected operations of the electrical circuit, and wherein the model is partially based on empirical operation sampling.

In another example of any of the above described exemplary methods for detecting a high impedance fault in an electrical circuit the expected operations model is a model of expected operations of the electrical circuit based on commanded parameters of the electrical circuit.

In another example of any of the above described exemplary methods for detecting a high impedance fault in an electrical circuit the electrical circuit is a motor controller.

In another example of any of the above described exemplary methods for detecting a high impedance fault in an electrical circuit, the expected operations model is a mathematical model of expected electrical powertrain operations and the operational model is a mathematical model of actual electrical powertrain operations.

According to the invention, a motor controller circuit is provided as claimed in claim 8 and includes an electrical powertrain including a three phase input, a DC link and a three phase output, a controller including a processor and a memory, a first current sensor configured to sense a current at the three phase input, a second current sensor configured to sense a current at the three phase output, and a third sensor configured to sense a current at the DC link, and wherein the memory stores instructions configured to cause the processor to perform the method as described above.

Another exemplary embodiment of the above described motor controller circuit further includes a fault protection circuit connected to the three phase input.

In another exemplary embodiment of any of the above described motor controller circuits the faulty protection circuit is a fuse type circuit.

In another exemplary embodiment of any of the above described motor controller circuits the memory further includes instructions configured to cause the processor to activate a fault protection circuit in response to the threshold being exceeded.

In another exemplary embodiment of any of the above described motor controller circuits activating the fault protection circuit comprises simulating a low impedance fault.

In another exemplary embodiment of any of the above described motor controller circuits simulating a low impedance fault comprises placing a DC/AC converter within the powertrain in a crowbar mode.

These and other features of the present invention can be best understood from the following specification and drawings, the following of which is a brief description.

## BRIEF DESCRIPTION OF THE DRAWINGS

Figure 1 schematically illustrates an exemplary motor controller system.
Figure 2 schematically illustrates the motor controller electrical powertrain of Figure 1 in more detail.
Figure 3 schematically illustrates a controller process for controlling the powertrain of Figure 2.

## DETAILED DESCRIPTION OF AN EMBODIMENT

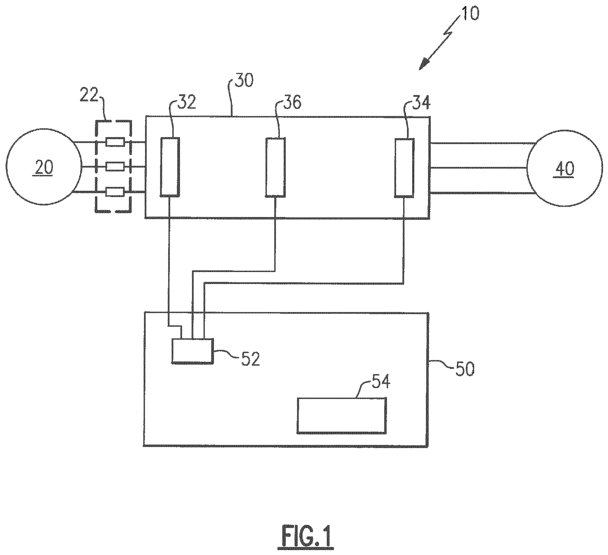

Figure 1 schematically illustrates a motor controller system 10 including a three phase power source 20. The three phase power source 20 is connected to an electrical powertrain 30. The electrical powertrain 30 outputs three phase power to a motor 40, and drives the rotation of the motor 40. A controller 50 controls operation of the electrical powertrain 30, and thereby controls a voltage output to the motor 40. The voltage output to the motor 40, in turn, controls the rotational speed and the torque of the motor 40. The connections between the three phase power source 20 and the electrical powertrain 30 are fused connections 22 and are configured to trip (disconnect) when the current through the corresponding connection exceeds a threshold value. Typically, the threshold value is determined to be an expected low impedance fault value.

In alternative examples, the fused connections 22 can be replaced with any other fault detection and protection circuit. In such examples, additional current sensing and voltage sensing (not pictured) can be included within the electrical powertrain 30 as needed.

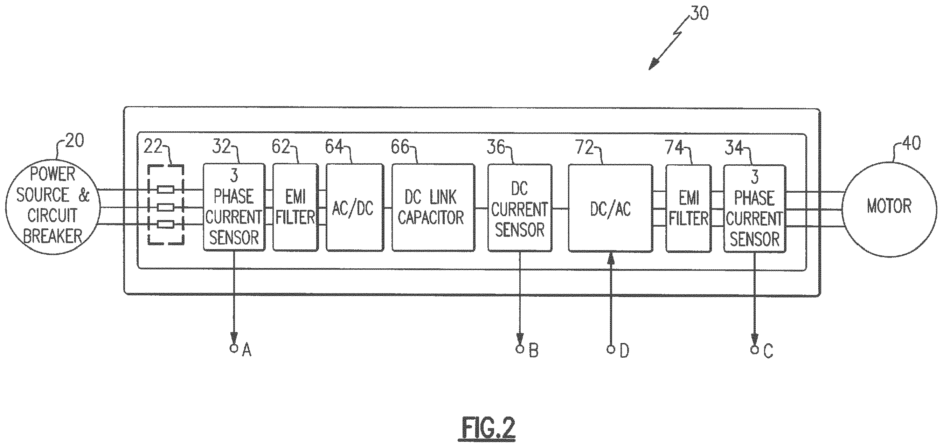

Included within the electrical powertrain 30 is an input current sensor 32 configured to sense an input current on each phase of the three phase power from the power source 20 and an output current sensor 34 configured to sense the output current on each phase that is provided to the motor 40. Connected to a DC link portion (illustrated in Figure 2) is a DC current sensor 36. Each of the current sensors 32, 34, 36 provides a sensed output to the motor controller 50. In one exemplary implementation, the motor controller 50 includes a processor 52, and a memory 54. The processor 52 and memory 54 are configured to generate a pulse width modulation (PWM) signal to control the motor controller electrical powertrain 30 according to known PWM control principles.

With continued reference to Figure 1, Figure 2 schematically illustrates the internal components of the electrical powertrain 30, according to one example embodiment, in more detail. As illustrated in Figure 1, a three phase power source 20 is connected to the electrical powertrain 30 via a fused connection 22. A three phase input current sensor 32 senses the input currents and provides the current magnitude to the controller 50 (illustrated in Figure 1) via a sensor output A.

The three phase power is passed through the input current sensor 32 to an EMI (electromagnetic interference) filter 62. The EMI filter 62 removes electromagnetic noise from the three phase power input, and outputs "clean" three phase power.

The clean three phase power is provided to an AC/DC converter 64. The AC/DC converter 64 converts the three phase power to a DC power output, and provides the DC power output to a DC link capacitor 66. The DC link capacitor 66 ensures that any ripples, or other variations in the DC power output by the AC/DC converter 64, are smoothed and provides an output DC power to a DC current sensor 36. A sensed output of the DC current sensor 36 is provided to the controller 50 via a sensor output B.

A DC/AC converter 72 converts the DC voltage that passes through the DC current sensor 36 into a three phase power output, and provides the three phase power output to a second EMI filter 74. The DC/AC converter 72 includes a network of transistors that are operated by a PWM signal output from the controller 50 and received at a PWM signal input D.

The output of the EMI filter 74 is passed through a three phase current sensor 34 and drives the motor 40 to rotate. As with the input current sensor 32, the output current sensor 34 provides the sensed current information to the controller 50 via a sensor output C.

During operation of the electrical powertrain 30, an arc event can occur. An arc event is a condition where electrical current arcs (leaps via a spark) from an electrically live component or another live component to a neutral component. Arc events can occur due to excess voltages, stresses within the housing structure, manufacturing defects, or any number of other conditions. The arcing damages the components exposed to the electrical arc and can, in some instances, heats the housing or other neutral components beyond their melting points creating holes in the structure of the housing or other neutral components. As described above, typical fault detection and prevention circuits, such as the fused connection 22 illustrated in Figures 1 and 2, trip when a current through the protection circuit, or at a sensed location, exceeds a preset threshold.

Arc faults, such as those that can occur within the electrical powertrain 30 are in some cases high impedance arc faults. A high impedance arc fault is a continuous arc fault that has a relatively high resistance to current flow. As a result, the current through the fault detection circuit is not increased above the fault detection threshold and a fault is never registered. As a fault is never registered, the fault detection circuit does not trip. Absent some additional method for detecting a high impedance fault, the arcing is allowed to continue, compounding any damage that is generated as a result of the arc fault.

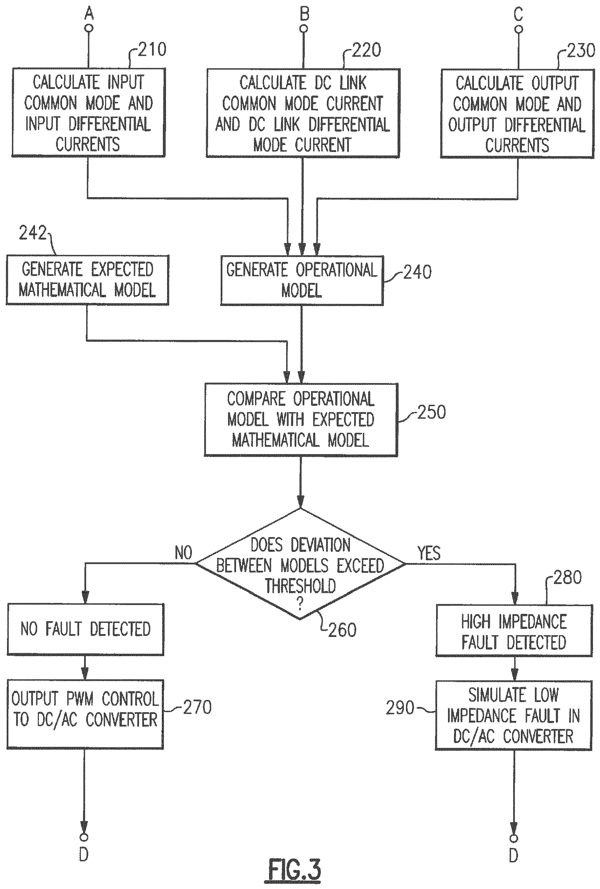

With continued reference to Figures 1 and 2, Figure 3 illustrates an exemplary process by which the controller processor 52 (illustrated in Figure 1) can detect and respond to a high impedance arc fault occurrence within a electrical powertrain 30. Initially the sensed output values are provided from the current sensors 32, 36, 34 to the processor 52 via the sensor output lines A, B and C. The processor 52 then simultaneously, or approximately simultaneously, calculates a common mode current and a differential mode current from each sensor based on the sensed values received via the sensor links A, B, and C in "Calculate Common Mode and Differential Mode Current" processes 210, 220 and 230. The differential mode component of the current is the direct measurement of the corresponding sensor 32, 34, 36. Calculating the common mode component of the current can be achieved by the following equation:

$$I_{cm} = I_a + I_b + I_c$$

Where $I_{cm}$ is the common mode current, $I_{a,b,c}$ are the currents in phases a, b, c respectively of the three phase supply.

The common mode current from the DC link sensor can be calculated using the following equation:

$$I_{cm\ dc} = I_{dc+} + I_{dc-}$$

Where $I_{cm\ dc}$ is the common mode current in the DC link and $I_{dc+}$ and $I_{dc-}$ are the positive and negative currents in the DC link.

Once the common mode and differential mode currents from each sensor link A, B, and C are determined, the processor 52 generates an operational model of the electrical powertrain 30 in a "Generate Operational Model" process 240. The operational model is a mathematical model of the operations of the electrical powertrain 30, and is generated according to any known mathematical modeling system. In some example embodiments, additional sensors can be included within the electrical powertrain 30 beyond the current sensors illustrated in Figures 1 and 2. By way of example, input voltage sensors, output voltage sensors, and the like can be included. When additional sensors are present, the operational model can utilize the additional sensed data to obtain a higher fidelity (more accurate) operational model. One of skill in the art, having the benefit of this disclosure, will recognize that inclusion of additional sensed data in the calculation of the operational model will necessarily increase the delay between an occurrence of an arc fault and the arc fault's detection.

Other example embodiments may change the location of the sensor. One example of which, locates the DC current sensor 36 between the AC/DC converter 64 and the DC link capacitor 66. One of skill in the art, having the benefit of this disclosure, will recognize that this alternative measurement location will provide a common mode current that can be calculated as described above. This alternative example embodiment can, in some cases, provide a cost savings when the sensors are additionally used for control of the AC/DC converter 64 along with the common mode current calculation.

Simultaneously with the generation of the operational model, the processor 52 generates an expected mathematical model in a "Generate Expected Mathematical Model" process 242. The expected mathematical model is a theoretical mathematical model of the expected operations of the electrical powertrain 30 based on the parameters set by the controller 50. By way of example, the parameters can include a commanded speed of the motor 40, a commanded torque of the rotor and a commanded voltage output of the electrical powertrain 30. As with the operational model, the expected theoretical model is generated using any known modeling technique. In some examples, the expected mathematical model is purely conceptual and is based solely on ideal component calculations. In other examples, the expected mathematical model is based at least in part on empirical operations data generated from one or more physical powertrains.

Once the expected mathematical model and the operational model are generated, the processor 52 compares the operational model against the expected mathematical model, and determines a magnitude of deviation between the two models in a "Compare Model With Expected Mathematical Model" process 250. The magnitude of the deviation is then compared against a threshold value in a "Does Deviation Between Models Exceed Threshold" check 260. In some examples, the deviation is a deviation between a common mode current of the three phase supply, a DC link common mode current, or a value dependent on one or both of the common mode current of the three phase power supply and the DC link common mode current.

If the deviation between the models does not exceed the threshold, no fault is detected in the operation of the electrical powertrain 30, and the controller 50 continues to output pulse width modulation (PWM) controls to the DC/AC converter 72 in an "Output PWM Control to DC/AC Converter" process 270.

In contrast, if the deviation between the models exceeds the threshold, a high impedance fault is detected in a "High Impedance Fault Detected" process 280. Once the high impedance fault is detected, the controller 50 trips the fault protection circuit (the fused connection 22), thereby preventing continued operation of the faulted electrical powertrain 30. In some examples, such as those where the fault protection circuit is a fuse style fault protection circuit, the controller 50 cannot directly trip the fault protection circuit. In such examples, the controller 50 operates the DC/AC converter 72 in a manner that simulates a low impedance fault in a "Simulate Low Impedance Fault in DC/AC Converter" process 290.

In order to simulate a low impedance fault, the controller 50 in one example commands each of the transistors in the DC/AC converter 72 to close simultaneously. As a result of the simultaneously closed transistors, the DC/AC converter 72 acts as a short across the DC link, allowing for a large current spike to be generated. The large current spike is sufficient to trip a fuse style fault protection circuit, or any similar fault protection circuit. Operating the transistors within the DC/AC converter 72 in this manner is referred to as crowbarring the DC/AC converter.

While described above with regards to operations within a motor controller, one of skill in the art will recognize that the system and process described herein can be applied to any electrical device or component susceptible to high impedance arc faulting, and is not limited to motor controller applications.

It is further understood that any of the above described concepts can be used alone or in combination with any or all of the other above described concepts. Although an embodiment of this invention has been disclosed, a worker of ordinary skill in this art would recognize that certain modifications would come within the scope of this invention. For that reason, the following claims should be studied to determine the true scope and content of this invention.

**Claims**

1. A method for detecting a high impedance fault in an electrical circuit (30) including a three phase supply unit, a DC link and a three phase output, the method comprising:

   comparing (250) an operational model of the electrical circuit against an expected operations model of the electrical circuit; and
   determining (260) that a high impedance fault exists within the electrical circuit in response to a deviation between the operational model and the expected operations model by at least a predetermined amount; wherein the deviation between the operational model and the expected operations model includes:

   a deviation between a common mode current (Icm) of the three phase supply input of the operational model and a common mode current of the three phase supply input of the expected operations model;
   a deviation between a DC link common mode current (Icm dc) of the operational model and a DC link common mode current of the expected operations model; and
a deviation between a value dependent on at least one of the common mode current of the three phase supply input and the DC link common mode current of each of the operational model and the expected operations model .

2. The method of claim 1, further comprising activating a fault protection circuit (22) in response to determining that a high impedance fault exists.

3. The method of claim 2, wherein activating a fault protection device comprises simulating a low impedance fault, thereby tripping the fault protection device.

4. The method of claim 3, wherein simulating a low impedance fault comprises placing a DC/AC converter (72) within the electrical circuit in a crowbar mode.

5. The method of claim 1, wherein the common mode current (Icm) of the three phase supply input of the operational model is calculated from the current in phases a, b, and c, at the three phase supply input, and calculating an input differential mode current, an output common mode current, an output differential mode current, the common mode current in the DC link, and a differential mode current in the DC link.

6. The method of claim 1, wherein the expected operations model is a model of expected operations of the electrical circuit (30), and wherein the model is partially based on empirical operation sampling, or wherein the expected operations model is a model of expected operations of the electrical circuit based on commanded parameters of the electrical circuit.

7. The method of any preceding claim, wherein the electrical circuit (30) is a motor controller.

8. A motor controller circuit comprising:

   an electrical powertrain (30) including a three phase supply input, a DC link and a three phase output;
   a controller (50) including a processor (52) and a memory (54);
   a first current sensor (32) configured to sense a current on each phase of the three phase supply input, a second current sensor (34) configured to sense a current on each phase of the three phase output, and a third sensor (36) configured to sense a current at the DC link; and
   wherein the memory (54) stores instructions configured to cause the processor (52) to perform the method of any of claims 1 to 7.

**9.** The motor controller of claim 8, further comprising a fault protection circuit connected to said three phase input.

**10.** The motor controller of claim 9, wherein the faulty protection circuit (22) is a fuse type circuit.

**11.** The motor controller of any of claims 8 to 10, wherein the memory (54) further includes instructions configured to cause the processor to activate a fault protection circuit in response to the threshold being exceeded.

**12.** The motor controller of claim 11, wherein activating the fault protection circuit comprises simulating a low impedance fault.

**13.** The motor controller of claim 12, wherein simulating a low impedance fault comprises placing a DC/AC converter (72) within said powertrain in a crowbar mode.

**Patentansprüche**

**1.** Verfahren zum Erkennen eines Fehlers mit hoher Impedanz in einem elektrischen Schaltkreis (30), welcher eine Dreiphasenversorgungseinheit, einen DC-Zwischenkreis und einen Dreiphasenausgang beinhaltet, wobei das Verfahren Folgendes umfasst:

> Vergleichen (250) eines betriebsfähigen Modells des elektrischen Schaltkreises mit einem erwarteten Betriebsmodell des elektrischen Schaltkreises; und
> Bestimmen (260), dass ein Fehler mit hoher Impedanz in dem elektrischen Schaltkreis existiert, als Reaktion auf eine Abweichung zwischen dem betriebsfähigen Modell und dem erwarteten Betriebsmodell um mindestens einen vorbestimmten Betrag; wobei die Abweichung zwischen dem betriebsfähigen Modell und dem erwarteten Betriebsmodell Folgendes beinhaltet:
>
>> eine Abweichung zwischen einem Gleichtaktstrom ($I_{cm}$) des Dreiphasenversorgungseingangs des betriebsfähigen Modells und einem Gleichtaktstrom des Dreiphasenversorgungseingangs des erwarteten Betriebsmodells;
>> eine Abweichung zwischen einem DC-Zwischenkreis-Gleichtaktstrom ($I_{cm\,dc}$) des betriebsfähigen Modells und einem DC-Zwischenkreis-Gleichtaktstrom des erwarteten Betriebsmodells; und
>> eine Abweichung zwischen einem Wert, welcher von mindestens einem des Gleichtaktstroms des Dreiphasenversorgungseingangs und des DC-Zwischenkreis-Gleichtaktstroms von jedem des betriebsfähigen Modells und des erwarteten Betriebsmodells abhängig ist.

**2.** Verfahren nach Anspruch 1, ferner umfassend Aktivieren eines Fehlerschutzschaltkreises (22) als Reaktion auf Bestimmen, dass ein Fehler mit hoher Impedanz existiert.

**3.** Verfahren nach Anspruch 2, wobei Aktivieren einer Fehlerschutzvorrichtung Simulieren eines Fehlers mit niedriger Impedanz umfasst, wodurch die Fehlerschutzvorrichtung ausgelöst wird.

**4.** Verfahren nach Anspruch 3, wobei Simulieren eines Fehlers mit niedriger Impedanz Platzieren eines DC/AC-Wandlers (72) in dem elektrischen Schaltkreis in einem Überspannungsmodus umfasst.

**5.** Verfahren nach Anspruch 1, wobei der Gleichtaktstrom (Icm) des Dreiphasenversorgungseingangs des betriebsfähigen Modells berechnet wird aus dem Strom in den Phasen a, b und c an dem Dreiphasenversorgungseingang und Berechnen eines Eingangsgegentaktstroms, eines Ausgangsgleichtaktstroms, eines Ausgangsgegentaktstroms, des Gleichtaktstroms in dem DC-Zwischenkreis und eines Gegentaktstroms in dem DC-Zwischenkreis.

**6.** Verfahren nach Anspruch 1, wobei das erwartete Betriebsmodell ein Modell von erwarteten Betrieben des elektrischen Schaltkreises (30) ist und wobei das Modell teilweise auf empirischen Betriebsabfragen basiert oder wobei das erwartete Betriebsmodell ein Modell von erwarteten Betrieben des elektrischen Schaltkreises basierend auf befohlenen Parametern des elektrischen Schaltkreises ist.

**7.** Verfahren nach einem der vorstehenden Ansprüche, wobei der elektrische Schaltkreis (30) eine Motorsteuerung ist.

**8.** Motorsteuerungsschaltkreis, umfassend:

> einen elektrischen Antriebsstrang (30), welcher einen Dreiphasenversorgungseingang, einen DC-Zwischenkreis und einen Dreiphasenausgang beinhaltet;
> eine Steuerung (50), welche einen Prozessor (52) und einen Speicher (54) beinhaltet;
> einen ersten Stromsensor (32), welcher dazu konfiguriert ist, einen Strom an jeder Phase des Dreiphasenversorgungseingangs zu erfassen, einen zweiten Stromsensor (34), welcher dazu konfiguriert ist, einen Strom an jeder Phase des Dreiphasenausgangs zu erfassen, und einen dritten Sensor (36), welcher dazu konfiguriert ist, einen Strom an dem DC-Zwischenkreis zu erfassen; und

wobei der Speicher (54) Anweisungen speichert, welche dazu konfiguriert sind, den Prozessor (52) dazu zu veranlassen, das Verfahren nach einem der Ansprüche 1 bis 7 durchzuführen.

9. Motorsteuerung nach Anspruch 8, ferner umfassend einen Fehlerschutzschaltkreis, welcher mit dem Dreiphaseneingang verbunden ist.

10. Motorsteuerung nach Anspruch 9, wobei der fehlerhafte Schutzschaltkreis (22) ein Sicherungstypschaltkreis ist.

11. Motorsteuerung nach einem der Ansprüche 8 bis 10, wobei der Speicher (54) ferner Anweisungen beinhaltet, welche dazu konfiguriert sind, den Prozessor dazu zu veranlassen, einen Fehlerschutzschaltkreis als Reaktion darauf zu aktivieren, dass der Schwellenwert überschritten wird.

12. Motorsteuerung nach Anspruch 11, wobei Aktivieren des Fehlerschutzschaltkreises Simulieren eines Fehlers mit niedriger Impedanz umfasst.

13. Motorsteuerung nach Anspruch 12, wobei Simulieren eines Fehlers mit niedriger Impedanz Platzieren eines DC/AC-Wandlers (72) in dem Antriebsstrang in einem Überspannungsmodus umfasst.

## Revendications

1. Procédé de détection d'une défaillance à haute impédance dans un circuit électrique (30) comportant une unité d'alimentation triphasée, une liaison CC et une sortie triphasée, le procédé comprenant :

la comparaison (250) d'un modèle opérationnel du circuit électrique à un modèle d'opérations attendues du circuit électrique ; et
le fait de déterminer (260) qu'une défaillance à haute impédance existe dans le circuit électrique en réponse à un écart entre le modèle d'opérations et le modèle d'opérations attendues d'au moins une quantité prédéterminée ; dans lequel l'écart entre le modèle d'opérations et le modèle d'opérations attendues comporte :

un écart entre un courant de mode commun ($I_{cm}$) de l'entrée d'alimentation triphasée du modèle d'opérations et un courant de mode commun de l'entrée d'alimentation triphasée du modèle d'opérations attendues ;
un écart entre un courant de mode commun ($I_{cm\,dc}$) de liaison CC du modèle d'opérations et un courant de mode commun de liaison CC du modèle d'opérations attendues ; et
un écart entre une valeur dépendant d'au moins un du courant de mode commun de l'entrée d'alimentation triphasée et du courant de mode commun de liaison CC du modèle d'opérations et du modèle d'opérations attendues.

2. Procédé selon la revendication 1, comprenant en outre l'activation d'un circuit de protection contre les défaillances (22) en réponse au fait de déterminer qu'une défaillance à haute impédance existe.

3. Procédé selon la revendication 2, dans lequel l'activation d'un dispositif de protection contre les défaillances comprend la simulation d'une défaillance à basse impédance, déclenchant ainsi le dispositif de protection contre les défaillances.

4. Procédé selon la revendication 3, dans lequel la simulation d'une défaillance à basse impédance comprend le placement d'un convertisseur CC/CA (72) à l'intérieur du circuit électrique dans un mode circuit limiteur.

5. Procédé selon la revendication 1, dans lequel le courant de mode commun ($I_{cm}$) de l'entrée d'alimentation triphasée du modèle d'opérations est calculé à partir du courant dans les phases a, b et c, au niveau de l'entrée d'alimentation triphasée, et du calcul d'un courant de mode différentiel d'entrée, d'un courant de mode commun de sortie, d'un courant de mode différentiel de sortie, du courant de mode commun dans la liaison CC, et d'un courant de mode différentiel dans la liaison CC.

6. Procédé selon la revendication 1, dans lequel le modèle d'opérations attendues est un modèle d'opérations attendues du circuit électrique (30), et dans lequel le modèle est partiellement basé sur un échantillonnage d'opérations empirique, ou dans lequel le modèle d'opérations attendues est un modèle d'opérations attendues du circuit électrique sur la base de paramètres commandés du circuit électrique.

7. Procédé selon une quelconque revendication précédente, dans lequel le circuit électrique (30) est un dispositif de commande de moteur.

8. Circuit de dispositif de commande de moteur, comprenant :

un groupe motopropulseur électrique (30) comportant une entrée d'alimentation triphasée, une liaison CC et une sortie triphasée ;
un dispositif de commande (50) comportant un processeur (52) et une mémoire (54) ;

un premier capteur de courant (32) configuré pour détecter un courant sur chaque phase de l'entrée d'alimentation triphasée, un deuxième capteur de courant (34) configuré pour détecter un courant sur chaque phase de la sortie triphasée, et un troisième capteur (36) configuré pour détecter un courant au niveau de la liaison CC ; et

dans lequel la mémoire (54) stocke des instructions configurées pour amener le processeur (52) à exécuter le procédé selon l'une quelconque des revendications 1 à 7.

9. Dispositif de commande de moteur selon la revendication 8, comprenant en outre un circuit de protection contre les défaillances relié à ladite entrée triphasée.

10. Dispositif de commande de moteur selon la revendication 9, dans lequel le circuit de protection contre les défaillances (22) est un circuit de type à fusibles.

11. Dispositif de commande de moteur selon l'une quelconque des revendications 8 à 10, dans lequel la mémoire (54) comporte en outre des instructions configurées pour amener le processeur à activer un circuit de protection contre les défaillances en réponse au dépassement du seuil.

12. Dispositif de commande de moteur selon la revendication 11, dans lequel l'activation du circuit de protection contre les défaillances comprend la simulation d'une défaillance à basse impédance.

13. Dispositif de commande de moteur selon la revendication 12, dans lequel la simulation d'une défaillance à basse impédance comprend le placement d'un convertisseur CC/CA (72) à l'intérieur dudit groupe motopropulseur dans un mode circuit limiteur.

FIG.1

FIG.2

EP 3 208 623 B1

A

CALCULATE INPUT COMMON MODE AND INPUT DIFFERENTIAL CURRENTS ~210

B

CALCULATE DC LINK COMMON MODE CURRENT AND DC LINK DIFFERENTIAL MODE CURRENT ~220

C

CALCULATE OUTPUT COMMON MODE AND OUTPUT DIFFERENTIAL CURRENTS ~230

242~ GENERATE EXPECTED MATHEMATICAL MODEL

GENERATE OPERATIONAL MODEL ~240

COMPARE OPERATIONAL MODEL WITH EXPECTED MATHEMATICAL MODEL ~250

DOES DEVIATION BETWEEN MODELS EXCEED THRESHOLD ? ~260

NO

YES

NO FAULT DETECTED

HIGH IMPEDANCE FAULT DETECTED ~280

OUTPUT PWM CONTROL TO DC/AC CONVERTER ~270

290~ SIMULATE LOW IMPEDANCE FAULT IN DC/AC CONVERTER

D

D

FIG.3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2009296289 A
- EP 2677618 A